# EUROPÄISCHE PATENTSCHRIFT

(11) **EP 3 986 097 B1**
(45) Veröffentlichungstag und Bekanntmachung des Hinweises auf die Patenterteilung: **04.12.2024**
(21) Anmeldenummer: 20202251.3
(22) Anmeldetag: 16.10.2020
(51) Int. Cl.: H05K 5/00

(54) **REMOTE-I/O-SYSTEM**
REMOTE I/O SYSTEM
SYSTÈME E/S DISTANT

(43) Veröffentlichungstag der Anmeldung: 20.04.2022
(73) Patentinhaber: BEx-Solution GmbH, 76199 Karlsruhe (DE)
(72) Erfinder: Bauermeister, Ralf, 76199 Karlsruhe (DE)
(74) Vertreter: Karzel, Philipp

(56) Entgegenhaltungen:
- JP-A- 2005 348 542

## Beschreibung

Die Erfindung betrifft ein Remote-I/O-System nach dem Oberbegriff des Anspruchs 1.

Ein Remote-I/O-System (Remote-Input/Output-System) zum Einsatz in einem explosionsgefährdeten Bereich umfasst ein Remote-I/O-Modul (Remote-Input/Output-Modul). Das Remote-I/O-Modul ist zur sicheren Verbindung von Sensoren und Aktoren mit einem Leitsystem, beispielsweise einem Computer vorgesehen. Das Remote-I/O-Modul kann dezentral angeordnet werden und Prozessdaten von binären und analogen Sensoren und Aktoren beispielsweise über eine Busschnittstelle des Remote-I/O-Moduls aus dem explosionsgefährdeten Bereich an das Leitsystem übertragen. Genauso können Prozessdaten über das Remote-I/O-Modul vom Leitsystem in den explosionsgefährdeten Bereich übertragen werden. Aufgrund des durch das Remote-I/O-Modul reduzierten Verdrahtungsaufwands können nicht nur Kabel, sondern auch Zeit, Geld und Arbeitsaufwand eingespart werden. Damit das Remote-I/O-Modul nicht als Zündquelle für eine Explosion dienen kann, ist es so ausgelegt, dass trotz der durch das Remote-I/O-Modul miteinander verbundenen Kabel keine Funken entstehen können und das Remote-I/O-Modul einen vorgegebenen Temperaturwert nicht überschreitet. Zum Schutz vor Staub, insbesondere vor entzündlichem Staub, und mechanischen Einwirkungen ist das Remote-I/O-Modul in einem Gehäuse angeordnet. Das Gehäuse umgibt das Remote-I/O-Modul allseitig, so dass es vollständig in dem Gehäuse eingeschlossen ist. Das Gehäuse kann das Remote-I/O-Modul auch vor Gasen, insbesondere vor entzündlichen Gasen abschirmen. Derartige Gehäuse schließen ein großes Volumen ein, das um ein Vielfaches größer ist als das Bauraumvolumen des Remote-I/O-Moduls. In der Folge benötigt das gesamte Remote-I/O-System einen großen Bauraum. Typischerweise ist das Gehäuse ein Schaltschrank. Das Gehäuse weist einen Kasten und einen Deckel auf. Um den Deckel öffnen zu können und den Zustand des Remote-I/O-Moduls anhand von einer Anzeige des Remote-I/O-Moduls überprüfen zu können, muss zunächst sichergestellt werden, dass beim Öffnen des Gehäuses keine entzündlichen Gase zum Remote-I/O-Modul vordringen können. Hierzu muss die Gaskonzentration der Umgebungsluft in einer sogenannten Freimessung bestimmt werden.

Aus der JP 2005-348542 A ist ein Radio zum Einsatz in einem explosionsgefährdetem Bereich bekannt, dessen Grundkörper elektrische Kontakte aufweist und der in einem Gehäuse angeordnet sind. Von den elektrischen Kontakten des Grundkörpers sind Kabel durch einen Deckel des Gehäuses geführt. Das Gehäuse schließt ein großes Bauraumvolumen ein.

Der Erfindung liegt die Aufgabe zugrunde, ein gattungsgemäßes Remote-I/O-System derart weiterzubilden, dass das Remote-I/O-System einen kleinen Bauraum benötigt.

Diese Aufgabe wird durch ein Remote-I/O-System mit den Merkmalen des Anspruchs 1 gelöst.

Die Erfindung sieht vor, dass der Deckel des Gehäuses unmittelbar auf dem Grundkörper des Remote-I/O-Moduls aufliegt. Dadurch besteht zwischen dem Remote-I/O-Modul und dem Deckel kein Abstand. Dadurch kann das Remote-I/O-System so gestaltet sein, dass zwischen Deckel und Remote-I/O-Modul kein Freiraum ist. Auf diese Weise kann Bauraum eingespart werden. Das Remote-I/O-System kann platz- und materialsparend hergestellt werden.

Vorteilhaft ist der Kasten des Remote-I/O-Systems durch den Grundkörper des Remote-I/O-Moduls ausgebildet. Zweckmäßig sind der Kasten und der Grundkörper integral miteinander ausgebildet. Insbesondere sind der Kasten und der Grundkörper materialeinheitlich ausgebildet. Dadurch sind der Kasten des Remote-I/O-Systems und der Grundkörper des Remote-I/O-Moduls dasselbe Bauteil. Dies spart Material und vereinfacht die Herstellung. Darüber hinaus baut das Remote-I/O-System dadurch kleiner. Das Remote-I/O-System ist dadurch kompakter und stabiler. Das Remote-I/O-Modul umfasst bereits das Gehäuse. Es wird kein zusätzliches bzw. separates Schutzgehäuse benötigt. Das Remote-I/O-Modul kann direkt im explosionsgefährdeten Bereich verbaut werden.

Zweckmäßig weist das Gehäuse mindestens eine Durchführöffnung zur Durchführung der elektrischen Leitung auf. Dadurch kann eine elektrische Leitung auf einfache Weise durch die Durchführung mit dem mindestens einen Anschluss verbunden werden.

Insbesondere ist die Durchführöffnung eine Kabelverschraubung zur dichten Leitungseinführung von einer Außenseite des Gehäuses zu einer Innenseite des Gehäuses. Vorteilhaft ist die Kabelverschraubung ein Panzergewinde. Dadurch können Kabel ins Innere des Gehäuses eingeführt werden, und das Gehäuse ist dennoch nach außen hin dicht.

Vorteilhaft ist die Durchführöffnung im Grundkörper ausgebildet. Dadurch kann ein durch die Durchführöffnung geführtes Kabel auf einfache Weise mit dem mindestens einen Anschluss verbunden werden. Dadurch kann das Remote-I/O-System flach gestaltet sein.

In alternativer Ausgestaltung ist die Durchführöffnung im Deckel ausgebildet. Bei einem defekten Remote-I/O-Modul genügt es, lediglich den Grundkörper des Remote-I/O-Moduls zu ersetzen. Das Kabel kann durch den Deckel durchgeführt bleiben, und der Deckel kann gemeinsam mit dem Kabel auf einen neuen Grundkörper gesetzt werden. Dies spart Zeit und Material. Vorteilhaft weist der mindestens eine Anschluss eine Klemm- oder Rastverbindung auf. Diese kann bei einem Austausch des Grundkörpers gelöst werden. Dadurch kann eine Verbindung des mindestens einen Kabels mit dem Grundkörper des Remote-I/O-Moduls auf einfache Weise gelöst und wieder geschlossen werden. Zweckmäßig können mehrere Kabel gleichzeitig durch eine Klemm- oder Rastverbindung mit dem Grundkörper verbunden werden.

Es kann auch vorgesehen sein, dass mehrere Durchführöffnungen vorgesehen sind. Insbesondere ist eine der mehreren Durchführöffnungen im Deckel und eine im Grundkörper vorgesehen.

Erfindungsgemäß weist der Grundkörper einen Aufnahmeraum für den Anschluss auf. Zweckmäßig ist der Aufnahmeraum durch eine Aufnahmeraumwand begrenzt, die geschlossen um eine Achse umläuft. Die Achse erstreckt sich insbesondere von einem Boden des Aufnahmeraums zu einer Öffnung des Aufnahmeraums. Dadurch liegt der Anschluss geschützt in dem Aufnahmeraum. Ein Deckel kann den Aufnahmeraum auf einfache Weise abdecken.

Zweckmäßig weist das Remote-I/O-System eine Außenwand zur Umgebung hin auf, die gleichzeitig die Außenwand des Kastens und des Grundkörpers ist. Vorteilhaft ist die Außenwand Teil der Aufnahmeraumwand. Dadurch kann das Remote-I/O-System beispielsweise so gestaltet sein, dass die Durchführöffnung durch die Aufnahmeraumwand direkt in den Aufnahmeraum führt. Dies erleichtert einen Anschluss des Kabels an den mindestens einen Anschluss.

Insbesondere weist der Aufnahmeraum eine Öffnung auf. Zweckmäßig ist die Öffnung durch den Deckel verschlossen. Vorteilhaft ist die Öffnung bezüglich des Durchgangs von Gasen, insbesondere von entzündlichen Gasen, dicht durch den Deckel verschlossen. Dadurch ist auf sichere Weise verhindert, dass Gase zu den Anschlüssen vordringen.

In vorteilhafter Weiterbildung der Erfindung weist das Remote-I/O-Modul eine Anzeige auf, die am Grundkörper ausgebildet ist und vom Deckel unverdeckt ist. Dadurch können die Anschlüsse geschützt durch den Deckel liegen, und gleichzeitig kann der Zustand des Remote-I/O-Moduls durch Blick auf die Anzeige überprüft werden. Ein Öffnen des Gehäuses ist hierfür nicht erforderlich. Vorteilhaft ist die Anzeige eine Leuchtanzeige.

Zweckmäßig ist im Grundkörper des Remote-I/O-Moduls mindestens eine elektrische Schaltung angeordnet. Die elektrische Schaltung ist insbesondere eine Platine. Vorteilhaft ist die elektrische Schaltung mittels eines elektrisch isolierenden Materials in den Grundkörper eingegossen. Zweckmäßig ist das elektrisch isolierende Material ein Kunstharz.

Insbesondere besteht der Grundkörper zumindest teilweise aus Aluminium. Zweckmäßig besteht der Deckel zumindest teilweise aus Aluminium.

Ein Ausführungsbeispiel der Erfindung wird im Folgenden anhand der Zeichnung erläutert. Es zeigen:
- Fig. 1 und 2: perspektivische Darstellungen eines Remote-I/O-Systems,
- Fig. 3 und 4: Seitenansichten des Remote-I/O-Systems aus den Figuren 1 und 2,
- Fig. 5: eine schematische Darstellung eines Schnitts entlang der Schnittebene V-V aus Fig. 4,
- Fig. 6: eine perspektivische Darstellung eines Deckels des Remote-I/O-Systems aus den Figuren 1 und 2,
- Fig. 7: eine schematische Darstellung eines Schnitts entlang der Schnittebene VII-VII aus Fig. 3 und
- Fig. 8: eine Seitenansicht des Remote-I/O-Systems aus den Figuren 1 und 2.

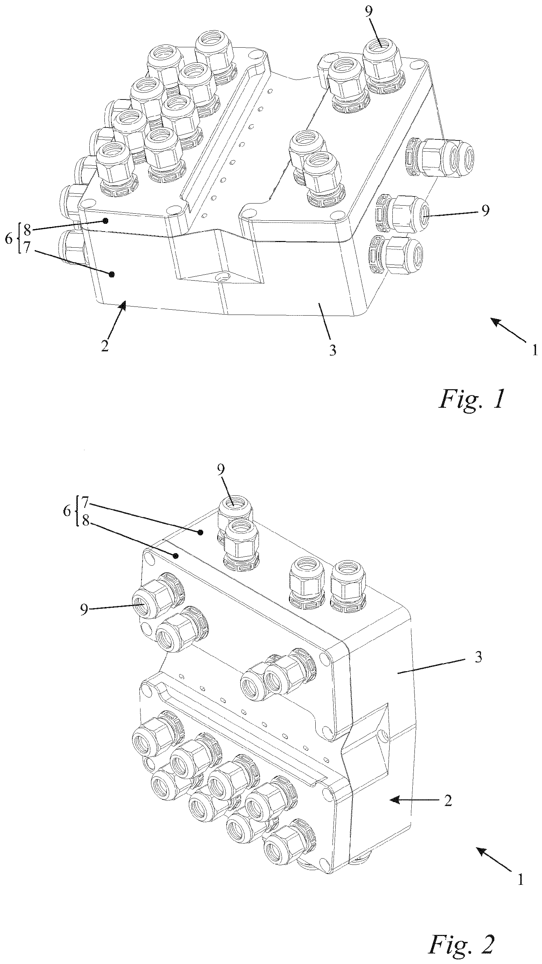

Fig. 1 zeigt ein Remote-I/O-System 1. Das Remote-VO-System 1 wird auch als Remote-Input/Output-System bezeichnet. Eine weitere Bezeichnung für das Remote-I/O-System 1 lautet Dezentrales-Eingabe/Ausgabe-System. Das Remote-I/O-System 1 umfasst ein Remote-I/O-Modul 2. In analoger Weise wird das Remote-I/O-Modul 2 auch als Remote-Input/Output-Modul oder als Dezentrales-Eingabe/Ausgabe-Modul bezeichnet.

Das Remote-I/O-Modul 2 weist eine nicht dargestellte Busschnittstelle auf. Über die Busschnittstelle des Remote-I/O-Moduls 2 lassen sich elektrische Signale übertragen. Mittels des Remote-I/O-Moduls 2 können Sensoren und/oder Aktoren mit einem Leitsystem verbunden werden (nicht dargestellt). Bei den Sensoren und/oder Aktoren kann es sich um digitale oder analoge Sensoren und/oder Aktoren handeln. Das Leitsystem ist beispielsweise eine Steuereinheit oder ein Computer. Im Ausführungsbeispiel ist das Leitsystem eine speicherprogrammierbare Steuerung. Typischerweise werden Prozessdaten von dem Sensor und/oder dem Aktor über das Remote-I/O-Modul 2 an das Leitsystem übermittelt bzw. werden Prozessdaten von dem Leitsystem über das Remote-I/O-Modul 2 an den Sensor und/oder dem Aktor übermittelt.

Das Remote-I/O-Modul 2 ist für den Einsatz in einem explosionsgeschützten Bereich ausgelegt. Der explosionsgeschützte Bereich wird auch als explosionsgefährdete Zone bezeichnet. Das Remote-I/O-Modul 2 ist so gestaltet, dass es keine Zündquelle für einen explosiven Stoff darstellt. Im Betrieb des Remote-I/O-Moduls 2 entstehen keine Funken. Das Remote-I/O-Modul 2 ist so ausgelegt, dass es eine vorgegebene Grenztemperatur nicht überschreitet. Das Remote-I/O-Modul 2 ist für den Einsatz in den gemäß der Richtlinie 2014/34/EU definierten Zonen 1 und 21 ausgelegt. Das Remote-I/O-System 1 ist für den Einsatz in den gemäß der Richtlinie 2014/34/EU definierten Zonen 1 und 21 ausgelegt. Demnach ist das Remote-I/O-Modul 2 für einen Bereich ausgelegt, in dem sich bei Normalbetrieb gelegentlich eine explosionsfähige Atmosphäre als Gemisch aus Luft und brennbaren Gasen, Dämpfen oder Nebeln bilden kann. Weiterhin ist das Remote-I/-Modul 2 für einen Bereich ausgelegt, in dem sich bei Normalbetrieb gelegentlich eine explosionsfähige Atmosphäre in Form einer Wolke aus in der Luft enthaltenem brennbarem Staub bilden kann. Das Remote-I/O-System 1 ist ebenfalls für diese beiden Bereiche ausgelegt.

Dadurch kann das Remote-I/O-System 1 dezentral in einem explosionsgefährdeten Bereich angeordnet sein. Im explosionsgefährdeten Bereich kann ein Sensor und/oder ein Aktor angeordnet sein, der über das Remote-I/O-System 1 mit einem Leitsystem verbunden ist, das außerhalb des explosionsgefährdeten Bereichs platziert ist. Dadurch kann der Sensor und/oder Aktor gefahrlos von dem Leitsystem aus gesteuert und/oder überwacht werden. Die Busschnittstelle des Remote-I/O-Moduls 2 sorgt für eine Reduzierung des Verdrahtungsaufwands.

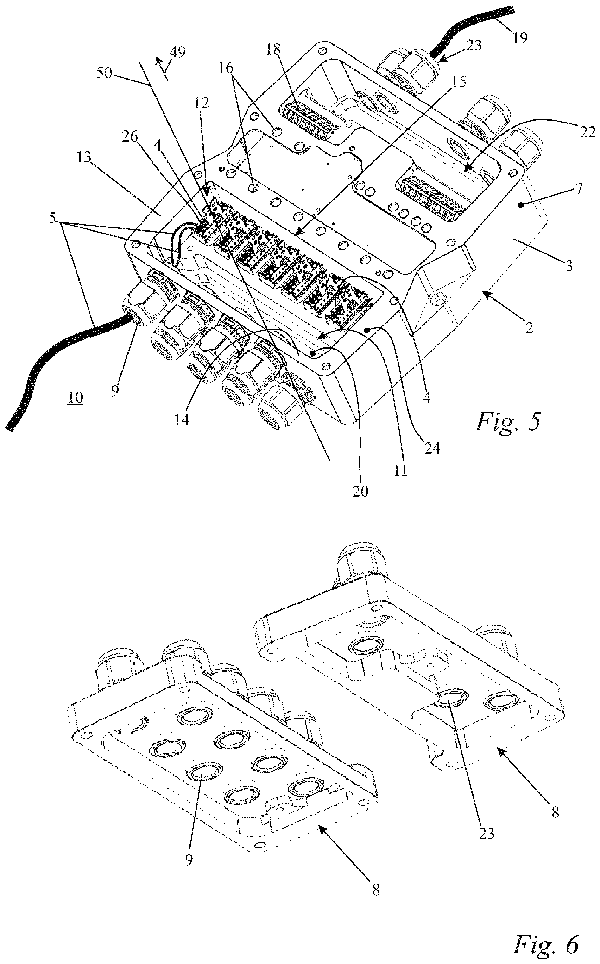

Das Remote-I/O-Modul 2 umfasst einen Grundkörper 3. An dem Grundkörper 3 ist mindestens ein Anschluss 4 angeordnet, wie in Fig. 5 dargestellt. Am Anschluss 4 kann eine Leitung 5 angeschlossen werden. Die Leitung 5 verbindet das Remote-I/O-Modul 2 mit einem Aktor und/oder einem Sensor (nicht dargestellt). An dem Grundkörper 3 ist ein Steueranschluss 18 angeordnet. Am Steueranschluss 18 kann eine Steuerleitung 19 angeschlossen werden. Die Steuerleitung 19 verbindet das Remote-I/O-Modul 2 mit dem Leitsystem. Die Steuerleitung 19 weist an ihrem dem Remote-I/O-Modul 2 zugewandten Ende einen nicht dargestellten Stecker auf. Mit dem Stecker ist die Steuerleitung in den Steueranschluss 19 gesteckt.

Das Remote-I/O-System 1 umfasst ein Gehäuse 6 (Figuren 1 und 2). Das Gehäuse 6 weist einen Kasten 7 und einen Deckel 8 auf. In dem Gehäuse 6 ist der Anschluss 4 angeordnet. Das Gehäuse 6 umgibt den Anschluss 4 allseitig. Das Gehäuse 6 schließt den Anschluss 4 vollständig ein. Der Anschluss 4 ist in dem Kasten 7 angeordnet. Das Gehäuse 6 ist dicht gegenüber Gasen, insbesondere gegenüber leicht entzündbaren Gasen.

Das Remote-I/O-System 1 ist gemäß DIN EN 60529 in der IP-Schutzart (International Protection-Schutzart oder Ingress Protection-Schutzart) IP67 ausgeführt. Demnach ist das Gehäuse 6 staubdicht. Das Gehäuse 6 bietet einen vollständigen Schutz gegen Berührung für die im Gehäuse 6 angeordneten Bauteile. Das Gehäuse 6 bietet einen Schutz gegen zeitweiliges Untertauchen.

Der Deckel 8 des Gehäuses 6 liegt unmittelbar an dem Grundkörper 2 des Remote-I/O-Moduls 2 an. Zwischen dem Grundkörper 2 und dem Deckel 8 besteht kein Abstand. Der Deckel 8 liegt flächig an dem Grundkörper 3 an. Der Grundkörper 2 weist einen Aufnahmeraum 12 für den Anschluss 4 auf (Fig. 5). Der Deckel 8 deckt den Aufnahmeraum 12 für den Anschluss 4 vollständig ab. Durch den Deckel 8 ist der Aufnahmeraum 12 dicht gegenüber Gasen verschlossen. Der Aufnahmeraum 12 bietet Platz für das durch die Durchführöffnung 9 geführte Ende der Leitung 5. Die einzelnen Adern der Leitung 5 sind im Aufnahmeraum 12 mit dem Anschluss 4 verbunden.

Der Kasten 7 des Gehäuses 6 des Remote-I/O-Systems 1 ist durch den Grundkörper 3 des Remote-I/O-Moduls 2 gebildet. Der Kasten 7 und der Grundkörper 3 sind einteilig ausgebildet. Der Kasten 7 und der Grundkörper 3 sind dasselbe Bauteil. Der Kasten 7 und der Grundkörper 3 sind materialeinheitlich ausgebildet. Der Grundkörper 3 ist aus Aluminium hergestellt. Die Oberfläche des Grundkörpers 3 ist durch eine Schutzschicht gebildet. Die Schutzschicht schützt vor Korrosion und mechanischer Beschädigung des Grundkörpers 3. Im Ausführungsbeispiel ist die Schutzschicht eine elektrochemisch abgeschiedene Metallschicht. Die Schutzschicht ist durch Galvanisieren aufgebracht. Es kann aber auch vorgesehen sein, dass die Schutzschicht durch Eloxieren des Aluminiums hergestellt ist. Alternativ oder zusätzlich kann der Grundkörper 3 auch zumindest teilweise aus Zink bestehen. Es kann vorgesehen sein, den Grundkörper in einem Zinkdruckguss-Verfahren herzustellen. Als weitere Möglichkeit kann der Grundkörper 3 zumindest teilweise aus Kunststoff bestehen. Vorteilhaft ist der Grundkörper 3 dann in einem Spritzgussverfahren hergestellt. Auch bei alternativen Materialien für den Grundkörper 3 kann eine schützende Oberflächenschicht auf der Oberfläche des Grundkörpers 3 vorgesehen sein. Eine Möglichkeit zur Aufbringung einer solchen Schutzschicht ist auch für Grundkörper aus Zink durch Galvanisieren gegeben.

Wie in Fig. 5 dargestellt, ist der Aufnahmeraum 12 durch eine Aufnahmeraumwand 13 begrenzt. Der Aufnahmeraum 12 weist einen Boden 20 auf. Der Boden 20 ist von der Aufnahmeraumwand 13 begrenzt. Der Aufnahmeraum 12 besitzt eine Öffnung 15. Die Öffnung 15 liegt dem Boden 20 gegenüber. Zwischen der Öffnung 15 und dem Boden 20 erstreckt sich die Aufnahmeraumwand 13. Durch den Aufnahmeraum 13 verläuft eine Achse 50. Die Achse 50 verläuft entlang einer Öffnungsrichtung 49. Die Öffnungsrichtung 49 zeigt vom Boden 20 zur Öffnung 15. Die Achse 50 durchstößt den Boden 20. Die Achse 50 weist einen Abstand zu der Aufnahmeraumwand 13 auf. Die Aufnahmeraumwand 13 schließt die Achse 50 ein. Die Aufnahmeraumwand 13 läuft geschlossen um die Achse 50 um. In einem geschlossenen Zustand des Gehäuses 6 ist die Öffnung 15 durch den Deckel 8 verschlossen. Um das Gehäuse 6 (Fig. 1) zu öffnen, wird der Deckel 8 (Fig. 6) in Öffnungsrichtung 49 vom Grundkörper 3 (Fig. 5) entfernt.

Das Remote-I/O-System 1 weist eine Außenwand 14 auf. Die Außenwand 14 begrenzt das Remote-I/O-System 1 bezüglich der Außenseite 10 des Remote-I/O-Systems 1 (Fig. 5). Die Außenwand 14 ist die Außenwand des Kastens 7. Die Außenwand 14 ist die Außenwand des Grundkörpers 3. Der Kasten 7 und der Grundkörper 3 besitzen die gemeinsame Außenwand 14. Ein Teil der Außenwand 14 ist Teil der Aufnahmeraumwand 13 des Aufnahmeraums 14.

Wie in Fig. 5 dargestellt, weist das Gehäuse 6 eine Durchführöffnung 9 zur Durchführung der elektrischen Leitung 9 auf. Durch die Durchführöffnung 9 ist von der Außenseite 10 zur Innenseite 11 des Gehäuses 6 die Leitung 5 geführt. Die Durchführöffnung 9 ist im Ausführungsbeispiel eine Kabelverschraubung. Mittels der Kabelverschraubung ist eine dichte Einführung der Leitung 5 von der Außenseite 10 zur Innenseite 11 möglich. Die Kabelverschraubung dichtet das Gehäuse 6 gegenüber Gasen ab. Im Ausführungsbeispiel ist die Kabelverschraubung ein Panzergewinde.

Im Ausführungsbeispiel ist sowohl im Grundkörper 3 (Fig. 5) als auch im Deckel 8 (Fig. 6) eine Durchführöffnung 9 angeordnet. Es kann aber auch vorgesehen sein, dass nur im Deckel 8 eine Durchführöffnung angeordnet ist. Der Grundkörper 3 ist dann frei von Durchführöffnungen. Genauso kann vorgesehen sein, dass nur im Grundkörper 3 eine Durchführöffnung angeordnet ist. Der Deckel 8 ist dann frei von Durchführöffnungen.

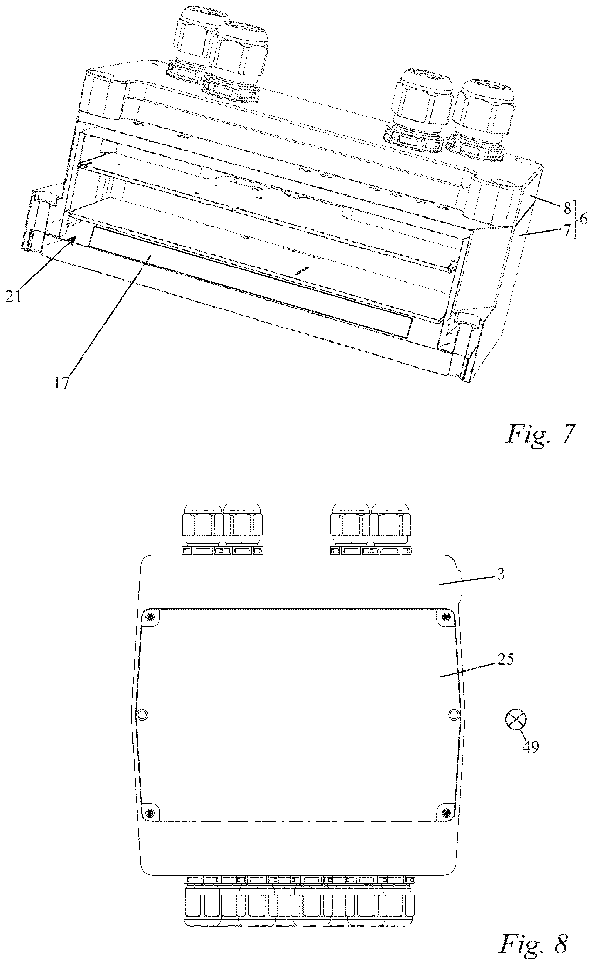

Das Kabel 5 ist durch die Durchführöffnung 9 geführt und mit dem Anschluss 4 verbunden (Fig. 5). Der Anschluss 4 ist im Ausführungsbeispiel eine Klemme. Die Klemme kann in mehreren Aufnahmen Drähte aufnehmen. Hierzu weisen die Aufnahmen jeweils eine Aufnahmeöffnung 26 auf. Der Anschluss 4 ist im Ausführungsbeispiel lösbar mit dem Grundkörper 3 verbunden. Dadurch kann die Leitung 5 auf komfortable Weise in gelöstem Zustand des Anschlusses 4 mit dem Anschluss 4 verbunden werden. Anschließend wird der Anschluss 4 wieder mit dem Grundkörper 3 verbunden. Die Klemme ist über eine Klemmverbindung mit dem Grundkörper 3 des Remote-I/O-Moduls 2 verbunden. Es kann aber auch vorgesehen sein, dass die Klemme über eine Rastverbindung mit dem Grundkörper 3 verbunden ist. Die Klemme weist an ihrem den Aufnahmeöffnungen 26 abgewandten Ende einen elektrischen Kontakt auf (nicht dargestellt). Im eingesteckten Zustand der Klemme kontaktiert der elektrische Kontakt eine elektrische Schaltung 17 (Fig. 7) des Remote-I/O-Moduls 2. In analoger Weise sind mehrere elektrische Kontakte vorhanden. Durch die Kombination aus den Aufnahmen der Klemme und den elektrischen Kontakten sind digitale Eingänge und Ausgänge des Remote-I/O-Moduls 2 ausgebildet. Die digitalen Eingänge sind gemäß des Namur-Standards ausgelegt. Die digitalen Ausgänge sind für eine Spannung von 24V ausgelegt. Über eine Stromschleifenschnittstelle können analoge Sensoren und/oder Aktoren an das Remote-EO-Modul 2 angeschlossen werden. Der Schleifenstrom kann von 4 mA bis 20 mA betragen.

Wie in der Schnittdarstellung in Fig. 7 dargestellt, ist im Inneren des Grundkörpers 3 ein Fach 21 ausgebildet. Das Fach 21 dient zur Aufnahme der elektrischen Schaltung 17. Die elektrische Schaltung 17 ist eine Platine. Die elektrische Schaltung 17 ist in ein elektrisch isolierendes Material eingebettet. Das elektrisch isolierende Material ist Kunstharz. Die elektrische Schaltung 17 ist mittels des elektrisch isolierenden Materials in den Grundkörper 3 eingegossen. Hierzu ist das Fach 21 mit dem elektrisch isolierenden Material gefüllt. Die Klemme verbindet die Leitung 5 mit der elektrischen Schaltung 17.

Wie in Fig. 5 dargestellt, weist der Grundkörper einen zweiten Aufnahmeraum 22 auf. Der zweite Aufnahmeraum 22 dient zur Aufnahme des Steueranschlusses 18. Der zweite Aufnahmeraum 22 ist analog zum Aufnahmeraum 12 durch einen Deckel 8 abgedeckt. Der Steueranschluss 18 verbindet die Steuerleitung 19 mit der elektrischen Schaltung 17. Die Steuerleitung 19 ist durch eine zweite Durchführung 23 von der Innenseite 11 zur Außenseite 10 geführt. Die zweite Durchführung 23 ist analog zur Durchführung 9 ausgebildet. Auch sie kann sowohl im Deckel 8 (Fig. 6) als auch im Grundkörper 3 (Fig. 5) vorgesehen sein. Genauso kann sie entweder nur im Deckel oder nur im Grundkörper vorgesehen sein.

Der in Fig. 6 gezeigte Deckel 8 ist aus Aluminium hergestellt. Die Oberfläche des Deckels 8 ist durch eine Schutzschicht gebildet. Die Schutzschicht schützt vor Korrosion und mechanischer Beschädigung des Deckels 8. Im Ausführungsbeispiel ist die Schutzschicht eine elektrochemisch abgeschiedene Metallschicht. Die Schutzschicht ist durch Galvanisieren aufgebracht. Es kann aber auch vorgesehen sein, dass die Schutzschicht durch Eloxieren des Aluminiums hergestellt ist.

Es kann vorgesehen sein, dass in dem in Fig. 5 dargestellten Grundkörper 3 eine Vertiefung zur Aufnahme eines Vorsprungs des Deckels 8 angeordnet ist. Die Vertiefung erstreckt sich in Richtung entgegen der Öffnungsrichtung 49. Vorteilhaft läuft die Vertiefung geschlossen um die Achse 50 um. Insbesondere ist die Vertiefung in einer Stirnseite 24 der Aufnahmeraumwand 13 angeordnet. Die Aufnahmeraumwand 13 läuft geschlossen um die Achse 50 um. Zweckmäßig läuft der Vorsprung des Deckels 8 bei Anordnung auf dem Aufnahmeraum 13 geschlossen um die Achse 50 um. Vorteilhaft ist der Vorsprung des Deckels 8 korrespondierend zu der Vertiefung des Grundkörpers 3 ausgebildet. Die Vertiefung kann auch als Nut und der Vorsprung als Feder bezeichnet werden. Durch das Zusammenspiel von Vorsprung und Vertiefung ist eine einfache Positionierung des Deckels 8 auf dem Grundkörper 3 möglich. Das Zusammenspiel von Vorsprung und Vertiefung sorgt für eine dichte Verbindung von Deckel 8 und Grundkörper 3. Es kann auch vorgesehen sein, dass zwischen dem Vorsprung und der Vertiefung eine Dichtung angeordnet ist. Alternativ kann der Vorsprung auch am Grundkörper 3 und die Vertiefung im Deckel 8 vorgesehen sein.

Der Deckel 8 ist mittels mindestens eines nicht dargestellten Befestigungsmittels an dem Grundkörper 3 befestigt. Im Ausführungsbeispiel ist das Befestigungsmittel durch eine Schraube, ein Loch im Deckel 8 und ein Gewinde im Grundkörper 3 ausgebildet. Im Ausführungsbeispiel ist der Deckel 8 mit mehreren Schrauben auf dem Grundkörper 3 befestigt.

Im Ausführungsbeispiel ist die Öffnung 15 des Aufnahmeraums 12 in einer Ebene ausgebildet. Der Aufnahmeraum 12 ist in Öffnungsrichtung 49 geöffnet. Es kann aber auch vorgesehen sein, dass der Aufnahmeraum 12 in mehr als einer Richtung geöffnet ist, so dass an die Öffnung 15 mehrere Ebenen angelegt werden können. Der Deckel 8 ist dann zur Geometrie der Öffnung 15 korrespondierend ausgebildet. Beispielsweise kann die Form des Deckels 8 im Querschnitt im Wesentlichen L-förmig sein.

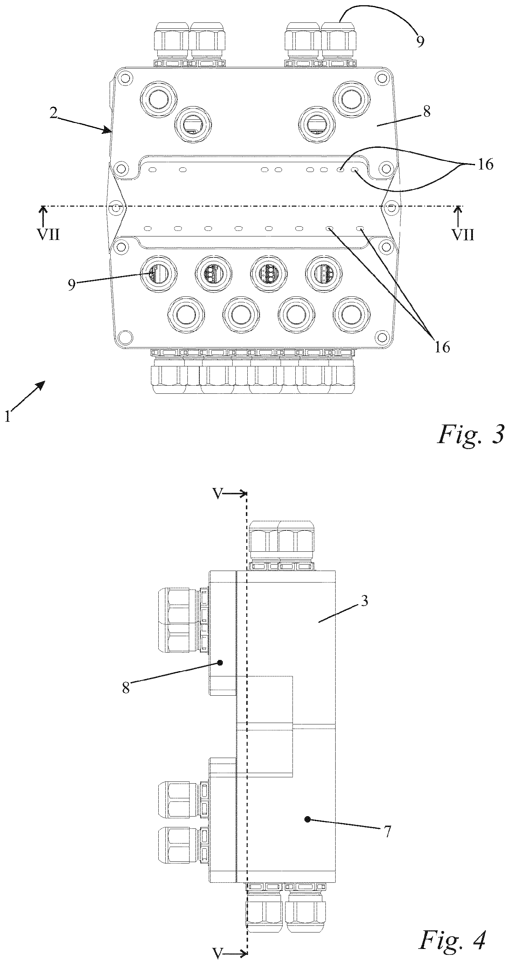

Wie in den Figuren 3 und 5 dargestellt, weist das Remote-EO-Modul 2 eine Anzeige 16 auf. Die Anzeige 16 ist eine Leuchtanzeige. Die Anzeige 16 ist durch LEDs gebildet. Es kann vorgesehen sein, dass die LEDs in Form eines Leuchtstabes eingesetzt werden. Die Anzeige 16 ist an der Innenseite 11 des Grundkörpers 3 befestigt und durch entsprechende Anzeigenöffnungen im Grundkörper 3 von der Außenseite 10 sichtbar. Die Anzeige 16 ist am Grundkörper 3 des Remote-I/O-Moduls 2 angeordnet. Die Anzeige 16 ist vom Deckel 8 unverdeckt. Die Anzeige 16 ist von der Außenseite 10 her auch bei geschlossenem Gehäuse 6 erkennbar.

Wie in Fig. 8 dargestellt, ist der Grundkörper 3 an seiner Unterseite von einer Abdeckung 25 verschlossen. Die Abdeckung 25 ist mittels Schrauben am Grundkörper 3 befestigt. Die Abdeckung 25 kann in Richtung entgegen der Öffnungsrichtung 49 vom Grundkörper 3 entfernt werden. Dadurch ist ein Zugang zu der elektrischen Schaltung 17 ermöglicht.

Das Remote-I/O-Modul 2 umfasst als Sicherheitsvorkehrung eine Strommessvorrichtung zur Messung des Stroms, der durch einzelne Kanäle fließt. Ebenso weist das Remote-I/O-Modul 2 eine Spannungsmessvorrichtung zur Detektion von Über- und/oder Unterspannungen auf. Das Remote-I/O-Modul 2 umfasst einen Temperatursensor, der die Temperatur des Remote-I/O-Moduls 2 misst.

Durch die Vielzahl von Messungen kann im Remote-I/O-Modul 2 bereits eine Erkennung von Fehlern erfolgen. Im einfachsten Fall kann das ein Kurzschluss, eine Spannung außerhalb des zulässigen Spannungsbereichs, eine zu hohe Temperatur oder eine Vorausfallanzeige (Predictive Maintenance) sein.

Die Auswertung dieser Messdaten kann durch das Leitsystem erfolgen. Im Ausführungsbeispiel ist hierfür eine Steuervorrichtung vorgesehen. Die Steuervorrichtung ist Bestandteil des Remote-I/O-Moduls 2.

Beim Überschreiten eines Grenzwerts für die Temperatur wird das Remote-I/O-Modul 2 durch die Steuervorrichtung abgeschaltet.

Die Steuervorrichtung des Remote-I/O-Moduls 2 trifft Entscheidungen aufgrund von gelernten Vorgängen. Hierzu ist in der Steuervorrichtung ein KI-Algorithmus hinterlegt, der eine künstliche Intelligenz darstellt.

Das Remote-I/O-Modul 2 kann durch die Steuervorrichtung selbstständig agieren. Durch den KI-Algorithmus der Steuervorrichtung kann das Remote-I/O-Modul 2 den Anlagenprozess selbstständig einlernen.

Die dem Remote-I/O-Modul 2 von den angeschlossenen Sensoren und/oder Aktoren zugeführten Daten und die Messdaten aus dem Remote-I/O-Modul 2 werden von dem KI-Algorithmus über einen längeren Zeitraum erfasst und ausgewertet. In der Steuervorrichtung ist ein künstliches neuronales Netzwerk ausgebildet, das mittels Deep Learning in den gesammelten Daten Strukturen erfasst und basierend hierauf Entscheidungen trifft. Insbesondere können hierdurch auftretende Anomalitäten zuverlässig als kritisch oder unkritisch eingeordnet werden. Dadurch kann der Datentransfer von dem Remote-I/O-Modul 2 zu dem Leitsystem reduziert werden. Die Daten müssen nicht permanent weitergeleitet oder abgefragt werden, sondern werden von der Steuervorrichtung vorgefiltert.

Es kann auch vorgesehen sein, dass die Steuervorrichtung das Leitsystem vollständig ersetzt. Die Steuervorrichtung steuert dann das Remote-I/O-Modul 2 vollständig selbstständig. Die einzelnen Steuerschritte werden durch den KI-Algorithmus geregelt.

## Patentansprüche

1. Remote-I/O-System zum Einsatz in einer explosionsgefährdeten Zone, wobei das Remote-I/O-System ein Remote-I/O-Modul (2) mit einem Grundkörper (3) umfasst, wobei an dem Grundkörper (3) mindestens ein Anschluss (4) für eine elektrische Leitung (5) angeordnet ist, wobei das Remote-I/O-System (1) ein Gehäuse (6) mit einem Kasten (7) und einem Deckel (8) umfasst, und wobei der Anschluss (4) allseitig von dem Gehäuse (6) umgeben ist, so dass der Anschluss vollständig in dem Gehäuse (6) eingeschlossen ist,
**dadurch gekennzeichnet, dass** der Grundkörper (3) einen Aufnahmeraum (12) für den Anschluss (4) aufweist, dass der Deckel (8) den Aufnahmeraum (12) vollständig abdeckt, dass der Deckel (8) des Gehäuses (6) unmittelbar auf dem Grundkörper (3) des Remote-I/O-Moduls (2) anliegt.

2. Remote-I/O-System nach Anspruch 1,
**dadurch gekennzeichnet, dass** der Kasten (7) des Remote-I/O-Systems (2) durch den Grundkörper (3) des Remote-I/O-Moduls (2) ausgebildet ist.

3. Remote-I/O-System nach Anspruch 1 oder 2,
**dadurch gekennzeichnet, dass** der Kasten (7) und der Grundkörper (3) integral miteinander ausgebildet sind.

4. Remote-I/O-System nach einem der Ansprüche 1 bis 3,
**dadurch gekennzeichnet, dass** der Kasten (7) und der Grundkörper (3) materialeinheitlich ausgebildet sind.

5. Remote-I/O-System nach einem der Ansprüche 1 bis 4,
**dadurch gekennzeichnet, dass** das Gehäuse (6) mindestens eine Durchführöffnung (9) zur Durchführung der elektrischen Leitung (5) aufweist.

6. Remote-I/O-System nach Anspruch 5,
**dadurch gekennzeichnet, dass** die Durchführöffnung (9) eine Kabelverschraubung zur dichten Leitungseinführung von einer Außenseite (10) des Gehäuses (6) zu einer Innenseite (11) des Gehäuses (6) ist.

7. Remote-I/O-System nach Anspruch 5 oder 6,
**dadurch gekennzeichnet, dass** die Durchführöffnung (9) im Grundkörper (3) ausgebildet ist.

8. Remote-I/O-System nach Anspruch 5 oder 6,
**dadurch gekennzeichnet, dass** die Durchführöffnung (9) im Deckel (8) ausgebildet ist.

9. Remote-I/O-System nach einem der Ansprüche 1 bis 8,
**dadurch gekennzeichnet, dass** der Aufnahmeraum (12) durch eine Aufnahmeraumwand (13) begrenzt ist, und dass die Aufnahmeraumwand (13) geschlossen um eine Achse (50) umläuft.

10. Remote-I/O-System nach einem der Ansprüche 1 bis 9,
**dadurch gekennzeichnet, dass** das Remote-I/O-System (1) eine Außenwand (14) zur Umgebung hin aufweist, und dass die Außenwand (14) gleichzeitig die Außenwand des Kastens (7) und des Grundkörpers (3) ist.

11. Remote-I/O-System nach den Ansprüchen 9 und 10,
**dadurch gekennzeichnet, dass** die Außenwand (14) Teil der Aufnahmeraumwand (13) ist.

12. Remote-I/O-System nach einem der Ansprüche 9 bis 11,
**dadurch gekennzeichnet, dass** der Aufnahmeraum (12) eine Öffnung (15) aufweist, und dass die Öffnung (15) durch den Deckel (8) verschlossen ist.

13. Remote-I/O-System nach einem der Ansprüche 1 bis 12,
**dadurch gekennzeichnet, dass** das Remote-I/O-Modul (2) eine Anzeige (16) aufweist, dass die Anzeige (16) am Grundkörper (3) ausgebildet ist, und dass die Anzeige (16) vom Deckel (8) unverdeckt ist.

14. Remote-I/O-System nach einem der Ansprüche 1 bis 13,
**dadurch gekennzeichnet, dass** im Grundkörper (3) des Remote-I/O-Moduls (2) mindestens eine elektrische Schaltung (17) angeordnet ist.

15. Remote-I/O-System nach Anspruch 14,
**dadurch gekennzeichnet, dass** die mindestens eine elektrische Schaltung (17) mittels eines elektrisch isolierenden Materials in den Grundkörper (3) eingegossen ist.

## Claims

1. Remote I/O system for use in a zone where there is an explosion hazard, wherein the remote I/O system comprises a remote I/O module (2) with a main body (3), wherein at least one connection (4) for an electrical line (5) is arranged on the main body (3), wherein the remote I/O system (1) comprises a housing (6) with a box (7) and a cover (8), and wherein the connection (4) is surrounded on all sides by the housing (6), so that the connection is completely enclosed in the housing (6),
**characterized in that** the main body (3) has a receiving space (12) for the connection (4), **in that** the cover (8) completely covers the receiving space (12), **in that** the cover (8) of the housing (6) lies directly on the main body (3) of the remote I/O module (2).

2. Remote I/O system according to Claim 1,
**characterized in that** the box (7) of the remote I/O system (2) is formed by the main body (3) of the remote I/O module (2).

3. Remote I/O system according to Claim 1 or 2,
**characterized in that** the box (7) and the main body (3) are formed integrally with one another.

4. Remote I/O system according to one of Claims 1 to 3,
**characterized in that** the box (7) and the main body (3) are formed from one and the same material.

5. Remote I/O system according to one of Claims 1 to 4,
**characterized in that** the housing (6) has at least one feedthrough-opening (9) for feeding through the electrical line (5).

6. Remote I/O system according to Claim 5,
**characterized in that** the feedthrough opening (9) is a screwed cable gland for the sealed introduction of a line from an outer side (10) of the housing (6) to an inner side (11) of the housing (6).

7. Remote I/O system according to Claim 5 or 6,
**characterized in that** the feedthrough opening (9) is formed in the main body (3).

8. Remote I/O system according to Claim 5 or 6,
**characterized in that** the feedthrough opening (9) is formed in the cover (8).

9. Remote I/O system according to one of Claims 1 to 8,
**characterized in that** the receiving space (12) is bounded by a receiving-space wall (13), and **in that** the receiving-space wall (13) runs continuously around an axis (50).

10. Remote I/O system according to one of Claims 1 to 9,
**characterized in that** the remote I/O system (1) has an outer wall (14) towards the surroundings, and **in that** the outer wall (14) is at the same time the outer wall of the box (7) and of the main body (3).

11. Remote I/O system according to either of Claims 9 and 10,
**characterized in that** the outer wall (14) is part of the receiving-space wall (13).

12. Remote I/O system according to one of Claims 9 to 11,
**characterized in that** the receiving space (12) has an opening (15), and **in that** the opening (15) is closed by the cover (8).

13. Remote I/O system according to one of Claims 1 to 12,
**characterized in that** the remote I/O module (2) has a display (16), **in that** the display (16) is formed on the main body (3), and **in that** the display (16) is not covered by the cover (8).

14. Remote I/O system according to one of Claims 1 to 13,
**characterized in that** in the main body (3) of the remote I/O module (2) there is at least one electrical circuit (17).

15. Remote I/O system according to Claim 14,
**characterized in that** the at least one electrical circuit (17) is encapsulated in the main body (3) by means of an electrically insulating material.

## Revendications

1. Système à Entrées/Sorties distantes destiné à être utilisé dans une zone à risque d'explosion, le système à Entrées/Sorties distantes comprenant un module d'Entrées/Sorties distantes (2) pourvu d'un corps de base (3), au moins une borne (4) destinée à une ligne électrique (5) étant disposée sur le corps de base (3), le système à Entrées/Sorties distantes (1) comprenant un boîtier (6) pourvu d'une boîte (7) et d'un couvercle (8), et la borne (4) étant entourée de tous côtés par le boîtier (6), de sorte que la borne est entièrement enfermée dans le boîtier (6),
**caractérisé en ce que** le corps de base (3) comporte un espace de réception (12) destiné à la borne (4), **en ce que** le couvercle (8) recouvre entièrement l'espace de réception (12), **en ce que** le couvercle (8) du boîtier (6) repose directement sur le corps de base (3) du module d'Entrées/Sorties distantes (2).

2. Système à Entrées/Sorties distantes selon la revendication 1,
**caractérisé en ce que** la boîte (7) du système à Entrées/Sorties distantes (2) est formée par le corps de base (3) du module d'Entrées/Sorties distantes (2).

3. Système à Entrées/Sorties distantes selon la revendication 1 ou 2,
**caractérisé en ce que** la boîte (7) et le corps de base (3) sont formés d'une seule pièce l'un avec l'autre.

4. Système à Entrées/Sorties distantes selon l'une des revendications 1 à 3, **caractérisé en ce que** le boîtier (7) et le corps de base (3) sont réalisés dans la même matière.

5. Système à Entrées/Sorties distantes selon l'une des revendications 1 à 4, **caractérisé en ce que** le boîtier (6) comporte au moins une ouverture de passage (9) destinée au passage de la ligne électrique (5).

6. Système à Entrées/Sorties distantes selon la revendication 5,
**caractérisé en ce que** l'ouverture de passage (9) est un passe-câble à vis destiné à l'entrée de câble étanche depuis un côté extérieur (10) du boîtier (6) jusqu'à un côté intérieur (11) du boîtier (6).

7. Système à Entrées/Sorties distantes selon la revendication 5 ou 6, **caractérisé en ce que** l'ouverture de passage (9) est ménagée dans le corps de base (3).

8. Système à Entrées/Sorties distantes selon la revendication 5 ou 6, **caractérisé en ce que** l'ouverture de passage (9) est ménagée dans le couvercle (8).

9. Système à Entrées/Sorties distantes selon l'une des revendications 1 à 8, **caractérisé en ce que** l'espace de réception (12) est délimité par une paroi d'espace de réception (13) et **en ce que** la paroi d'espace de réception (13) s'étend de manière fermée autour d'un axe (50).

10. Système à Entrées/Sorties distantes selon l'une des revendications 1 à 9, **caractérisé en ce que** le système à Entrées/Sorties distantes (1) comporte une paroi extérieure (14) en direction de l'environnement, et **en ce que** la paroi extérieure (14) est en même temps la paroi extérieure du boîtier (7) et celle du corps de base (3).

11. Système à Entrées/Sorties distantes selon les revendications 9 et 10, **caractérisé en ce que** la paroi extérieure (14) fait partie de la paroi d'espace de réception (13).

12. Système à Entrées/Sorties distantes selon l'une des revendications 9 à 11, **caractérisé en ce que** l'espace de réception (12) comporte une ouverture (15), et **en ce que** l'ouverture (15) est fermée par le couvercle (8).

13. Système à Entrées/Sorties distantes selon l'une des revendications 1 à 12, **caractérisé en ce que** le module d'Entrées/Sorties distantes (2) comporte un afficheur (16), **en ce que** l'afficheur (16) est formé sur le corps de base (3) et **en ce que** l'afficheur (16) n'est pas couvert par le couvercle (8).

14. Système à Entrées/Sorties distantes selon l'une des revendications 1 à 13, **caractérisé en ce qu'**au moins un circuit électrique (17) est disposé dans le corps de base (3) du module d'Entrées/Sorties distantes (2).

15. Système à Entrées/Sorties distantes selon la revendication 14, **caractérisé en ce que** l'au moins un circuit électrique (17) est moulé dans le corps de base (3) au moyen d'une matière électriquement isolante.
